(19) Europäisches Patentamt / European Patent Office / Office européen des brevets

(11) **EP 4 446 809 A2**

(12) **EUROPEAN PATENT APPLICATION**

(43) Date of publication:
**16.10.2024  Bulletin 2024/42**

(21) Application number: **24167570.1**

(22) Date of filing: **28.03.2024**

(51) International Patent Classification (IPC):
**G03F 1/22** *(2012.01)*    **G03F 1/38** *(2012.01)*

(52) Cooperative Patent Classification (CPC):
**G03F 1/24; G03F 1/38; G03F 1/84**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **11.04.2023  JP 2023064091**

(71) Applicant: **Shin-Etsu Chemical Co., Ltd.
Tokyo 100-0005 (JP)**

(72) Inventors:
• **Kishita, Takahiro**
  **Niigata (JP)**
• **Ozawa, Ryoken**
  **Niigata (JP)**

(74) Representative: **Mooser, Sebastian Thomas
Wuesthoff & Wuesthoff
Patentanwälte und Rechtsanwalt PartG mbB
Schweigerstraße 2
81541 München (DE)**

(54) **METHOD FOR EVALUATING REFERENCE MARK FORMED ON EUV MASK BLANK**

(57)    The present invention is a method for evaluating a reference mark formed on an EUV mask blank, the method including steps of: imaging the reference mark formed on the EUV mask blank to obtain a reference mark image; obtaining a reference mark contrast from the obtained reference mark image, the reference mark contrast being contrast between the reference mark and a background level; and evaluating processing accuracy of the reference mark with the obtained reference mark contrast. This provides a method for evaluating an EUV mask blank that can easily evaluate processing accuracy (for example, depth) of a reference mark.

[FIG. 1]

**Description**

TECHNICAL FIELD

The present invention relates to a method for evaluating a reference mark formed on a reflective mask blank for reflecting EUV light (EUV mask blank) used in manufacturing a semiconductor device, etc.

BACKGROUND ART

Semiconductor devices are manufactured by using photolithography technology in which a mask for transferring a pattern, such as a photomask with a drawn circuit pattern, is irradiated with exposure light to transfer the circuit pattern formed on the mask onto a semiconductor substrate via a reduction optical system. With miniaturization of the circuit pattern of the semiconductor devices, a wavelength of the exposure light has been mainly 193 nm using argon fluoride (ArF) excimer laser light, and adopting a process "multi-patterning" of combining exposure processes and processing processes a plurality of times can form a sufficiently small-sized pattern compared with the exposure light wavelength.

However, formation of a further finer pattern has been required with continuous miniaturization of a device pattern, and thereby EUV lithography technique using EUV light, which has a further shorter wavelength than the ArF excimer laser light, as the exposure light has been developed. More specifically, the EUV light is light having a wavelength of near 13.5 nm. Since the conventional transmission projection optical system and mask cannot be used for this EUV light, reflective optical elements are used.

Thus, a reflective mask is also proposed for a mask for transferring a pattern.

For the reflective mask, a multilayer reflective film to reflect EUV light is formed on a substrate, and an absorber film to absorb EUV light is patterned on the multilayer reflective film. Meanwhile, a state before the pattern is formed on the absorber film (including a state where a resist layer is formed) is called as a reflective mask blank, which is used as a material for the reflective mask. Hereinafter, the reflective mask blank for reflecting EUV light is also referred to as "EUV mask blank".

The EUV mask blank has a basic structure having: the multilayer reflective film formed on a low thermal-expansion substrate to reflect EUV light; and the absorber film formed thereon to absorb EUV light. Commonly used for the multilayer reflective film is a Mo/Si multilayer reflective film in which molybdenum (Mo) films and silicon (Si) films are alternately stacked to achieve reflectance of EUV light. Further, a protective film for protecting the multilayer reflective film is formed. Meanwhile, for the absorber film, a material mainly composed of tantalum (Ta) and chromium (Cr), which has a relatively large value of an extinction coefficient against EUV light, is used.

One of problems of the EUV lithography technique is information of defect positions on the EUV mask blank. In applying the EUV lithography, height abnormality of even approximately 1 nm generated on a surface of the multilayer reflective film of the reflective mask changes a phase of the reflected EUV light to cause change in size or resolution failure of a transferred pattern in transferring the absorber film pattern onto a wafer. Such height abnormality on the mask blank to change the phase is called as "phase defect".

Patent Document 1 discloses art of forming a reference mark on the absorber film, recognizing a position of the phase defect on the multilayer reflective film as a position of roughness on the surface of the absorber film thereon to convert the position into defect position information relative to the reference mark, and modifying a drawing data for pattering of the absorber film based on the defect position information to avoid the position of the phase defect and perform patterning of the absorber film. However, with some phase defects, structure turbulence of the multilayer reflective film to decrease the reflectance may be hardly exhibited as the roughness on the surface of the multilayer reflective film, and it is difficult to accurately obtain the positional information of all phase defects in inspection of the absorber film.

Accordingly, Patent Document 2 proposes that a reference mark is formed on the multilayer reflective film to specify defect positions based on this mark as a reference position, for example. Since the phase defect depends on not only simply the roughness on the surface of the multilayer reflective film but also roughness inside the reflective multilayer film and on a surface of the low thermal-expansion substrate, a inspection method using common laser light as inspection light cannot sufficiently detect the defects.

Thus, it is considered that suitable is a method for detecting the phase defect using inspection light having the same wavelength as EUV light used in exposure of the reflective mask, namely a so-called "at-wavelength inspection method". As an example of this method, Patent Document 3 discloses a method using a dark-field inspection image, for example.

CITATION LIST

PATENT LITERATURE

Patent Document 1: WO 2014/129527 A1
Patent Document 2: JP 2017-227936 A
Patent Document 3: JP 2003-114200 A

SUMMERY OF INVENTION

TECHNICAL PROBLEM

A reference mark on the EUV mask blank is an indicator for accurately defining the defect position, and thereby processing accuracy of the reference mark is an important quality parameter. For example, a case where the reference mark cannot be detected with an inspection apparatus due to considerable shift of the position of the reference mark from the designed position, etc. can be judged as processing failure of the reference mark.

However, the reference mark may be produced with a shallower depth than the design even when the reference mark is normally detected with an inspection apparatus, and such a defective product causes unevenness of detection sensitivity with the inspection apparatus. If such a defective product is shipped, the reference mark cannot be detected with an apparatus in a customer's process, which may cause quality failure. Thus, the processing accuracy of the reference mark is required to be evaluated, and can be measured by using an atomic force microscope (AFM) as the evaluation method, for example. However, the AFM measurement is destructive inspection, and the substrate itself used for producing the mask cannot be measured.

The present invention has been made in view of the above problem. An object of the present invention is to provide an EUV mask blank evaluation method that can easily evaluate processing accuracy of the reference mark (for example, depth).

SOLUTION TO PROBLEM

To achieve the above object, the present invention provides a method for evaluating a reference mark formed on an EUV mask blank, the method comprising steps of:

imaging the reference mark formed on the EUV mask blank to obtain a reference mark image;
obtaining a reference mark contrast from the obtained reference mark image, the reference mark contrast being contrast between the reference mark and a background level; and
evaluating processing accuracy of the reference mark with the obtained reference mark contrast.

The term "reference mark contrast" herein refers to a difference in light intensity between the reference mark portion and the background level portion in an image obtained by reflection of light irradiation on the reference mark on the EUV mask blank and obtained within a predetermined range of the EUV mask blank. That is, when the intensity of the reflected light in the reference mark portion is specified as "Imark" and the intensity of the reflected light in the background level portion is specified as "Ibgl", the reference mark contrast $\Delta$ is defined by:

$$\Delta = (Imark - Ibgl) / (Imark + Ibgl)$$

The present inventors have made earnest study, and found that the reference mark contrast $\Delta$ (hereinafter, also simply referred to as "contrast $\Delta$") has correlation with the processing accuracy (for example, depth) of the reference mark, and the processing accuracy of the reference mark can be evaluated by measuring the contrast $\Delta$. The present invention is a method for evaluating the EUV mask blank with this novel indicator, and the processing accuracy of the reference mark can be easily evaluated without destruction.

The evaluation method of the present invention enables total inspection without increasing a time of the evaluation step by simultaneously performing the method with defect inspection, for example.

In addition, the evaluation method of the present invention can eliminate products with abnormal processing accuracy of the reference mark to provide high-quality products.

Evaluating the processing accuracy of the reference mark may comprise:

a reference contrast obtaining step of preparing in advance a reference EUV mask blank with a varied depth of a reference mark, and obtaining a reference mark contrast of the reference EUV mask blank as a reference contrast;

an evaluation-target contrast obtaining step of preparing an evaluation-target EUV mask blank other than the reference EUV mask blank, and obtaining a reference mark contrast of the evaluation-target EUV mask blank as an evaluation-target contrast with an optical system same as in the reference contrast obtaining step; and

a quality judgement step of comparing the evaluation-target contrast and the reference contrast to judge quality of the reference mark of the evaluation-target EUV mask blank.

Such a method can more accurately evaluate the depth-processing accuracy of the reference mark, and can judge its quality (normality or abnormality) to determine good products among evaluation-target EUV mask blanks. This can more certainly provide the EUV mask blanks with stable quality.

Evaluating the processing accuracy of the reference mark may comprise:

a reference contrast obtaining step of preparing in advance a reference EUV mask blank with a varied depth of a reference mark, and obtaining a reference mark contrast of the reference EUV mask blank as a reference contrast;

a correlation data calculation step of obtaining a correlation formula between the reference contrast and the depth of the reference mark from the reference contrast and the depths of the reference marks in the reference EUV mask blank;

an evaluation-target contrast obtaining step of preparing an evaluation-target EUV mask blank other than the reference EUV mask blank, and obtaining a reference mark contrast of the evaluation-target EUV mask blank as an evaluation-target contrast with an optical system same as in the reference contrast obtaining step; and

a quality judgement step of evaluating the depth of the reference mark of the evaluation-target EUV mask blank from the evaluation-target contrast and the correlation formula obtained in the correlation data calculation step to judge quality of the reference mark of the evaluation-target EUV mask blank.

This method can also more accurately evaluate the depth-processing accuracy of the reference mark, and can judge its quality (normality or abnormality) to determine good products among evaluation-target EUV mask blanks. This can more certainly provide the EUV mask blanks with stable quality.

In imaging the reference mark formed on the EUV mask blank to obtain the reference mark image, the reference mark may be imaged with a Schwarzschild optical system and with a dark-field inspection image.

As above, the reference mark is suitably imaged with a Schwarzschild optical system and with a dark-field inspection image.

ADVANTAGEOUS EFFECTS OF INVENTION

According to the evaluation method of the present invention, the processing accuracy (specifically, depth) of the reference mark formed on the EUV mask blank can be easily evaluated without destruction. This can eliminate products with an abnormal reference mark to contribute to stable manufacturing in the customer's mask manufacturing step.

BRIEF DESCRIPTION OF DRAWINGS

FIG. 1 describes an example of an evaluation flowchart of the present invention using a reference mark contrast in EUV mask blank manufacturing;

FIG. 2 is an explanatory view illustrating an example of a reference mark; and

FIG. 3 is a graph indicating a relationship between: measured values of depths of reference marks #1 to #6; and a reference contrast ΔREF.

DESCRIPTION OF EMBODIMENTS

Hereinafter, embodiments of the present invention will be described with reference to the drawings, but the present invention is not limited thereto.

(First Embodiment)

First, described is a case where a reference mark contrast is applied as an indicator for evaluating processing accuracy of a reference mark on an EUV mask blank.

The evaluation method of the present invention comprises steps of: imaging the reference mark formed on the EUV mask blank to obtain a reference mark image; obtaining a reference mark contrast (contrast between the reference mark and the background level) from the obtained reference mark image; and evaluating processing accuracy of the reference mark on the EUV mask blank with the obtained reference mark contrast.

For obtaining the reference mark contrast (also simply referred to as "contrast"), the aforementioned formula is used.

Hereinafter, an example of processing accuracy of a depth of the reference mark as the processing accuracy of the reference mark will be described. However, the processing accuracy may be any as long as it is processing accuracy of an evaluable parameter with the reference mark contrast obtained from the reference mark image described later, and the present invention is not limited thereto. The depth of the reference mark can be measured by an AFM, etc.

In addition, the above steps may be performed only on the EUV mask blank being the evaluation target to evaluate the depth-processing accuracy of the reference mark. However, as described below, it is also acceptable that contrast condition is varied by varying a depth condition of the reference mark other than the evaluation target EUV mask blank to prepare a reference EUV mask blank for reference data, and the above steps are performed on both of them and obtained contrasts are compared with each other to perform the evaluation. In this case, the depth-processing accuracy of the reference mark can be more accurately evaluated.

Hereinafter, a more specific procedure will be described.

<Reference Contrast Obtaining Step>

First, the reference EUV mask blank is prepared. As described later, an EUV mask blank having the reference mark design equivalent to the evaluation-target EUV mask blank (product) but a different depth from the product may be prepared.

The actual EUV mask blank to be the evaluation target has films on a transparent substrate (glass substrate for a photomask). For the film constitution, for example, molybdenum (Mo) films and silicon (Si) films may be alternately stacked to form a Mo/Si multilayer reflective film to achieve reflectance of EUV light, and ruthenium (Ru) film may be further formed as a protective film for protecting the multilayer reflective film. The film-forming method is also not limited, and a sputtering method is applied, for example.

Then, a reference mark having a mark design equivalent to the product but different depth from the product is formed on the prepared EUV mask blank. A method for processing the reference mark may be various methods such as, for example, a focused ion beam (FIB) method and lithography process, and varying a processing condition may vary a depth condition.

The reference EUV mask blank with the varied depth of the reference mark is prepared as above. The number of the depth condition is one or more, but a plurality of the numbers is particularly preferable. The upper limit of the number is not particularly limited, and may be five to ten, for example. One reference EUV mask blank on which the plurality of the reference marks having different depths is formed may be prepared, or a plurality of same reference EUV mask blanks on which one reference mark having a different depth is each formed may be prepared.

Then, the reference mark on the reference EUV mask blank is imaged to obtain a reference mark image.

Any apparatus that can perform imaging to obtain the reference mark contrast later from the obtained image may be used, and a defect inspection apparatus that can obtain a defect image may be used, for example. It is particularly preferable to obtain a dark-field inspection image with a Schwarzschild optical system, but the method is not particularly limited. As the imaging conditions, a state where defects such as a foreign matter, a dimple, and a pinhole are absent in the image field including the reference mark is preferable because furthermore accurate evaluation can be performed.

A wavelength used for the imaging is not particularly limited as long as the reference mark image and the reference mark contrast can be obtained. The wavelength is preferably 600 nm or shorter, for example. The lower limit is not particularly limited, and the light may also be EUV light (approximately 1 nm to 100 nm, particularly around 13.5 nm), for example.

From the obtained reference mark image with different depths, each of the reference mark contrast is obtained. This is used as the reference contrast.

As the image, an image in which a difference in light intensity, etc. is emphasized by using an image-processing algorithm such as differential processing may be used as necessary.

<Evaluation-Target Contrast Obtaining Step>

Then, prepared is the actual evaluation-target EUV mask blank other than the reference EUV mask blank used in the reference contrast obtaining step. An image of the reference mark formed on the evaluation-target EUV mask blank is similarly obtained with an optical system same as in the reference contrast obtaining step, and the reference mark contrast is obtained from the reference mark image. This is used as the evaluation-target contrast.

<Quality Judgement Step (Contrast Comparison Step)>

Then, the obtained evaluation-target contrast is compared with the reference contrast for evaluating processing accuracy of the reference mark formed on the evaluation-target EUV mask blank to judge quality of the reference mark.

The criteria of the comparative evaluation here are not particularly limited. For example, the comparison may be performed with the obtained reference contrast itself, or criteria set based on the obtained reference contrast may be used. For example, a target contrast is set with reference to the reference contrast, and criteria within ±10% of the target contrast may be set as a normal value (good product). Alternatively, with an apparatus relating to detection of the reference mark, a lower detection limit contrast of the apparatus is evaluated and determined from the reference contrast obtained by evaluating the reference marks having different depths on the aforementioned reference EUV mask blank, and a case of the lower detection limit contrast or higher may also be set as a normal value (good product).

Based on such criteria, quality of the reference mark formed on the EUV mask blank can be managed. Such criteria can more certainly judge a reference mark with abnormal depth-processing accuracy among normal reference marks, and quality of the evaluation target can be judged with further higher accuracy. Thus, stabilization of the quality of the EUV mask blank can be more certainly achieved.

Of course, the criteria are not limited to the above "within ±10%", and a numerical range (threshold) being criteria may be set depending on desired evaluation criteria.

According to the evaluation method of the present invention as above, processing accuracy, such as depth, of the reference mark formed on the EUV mask blank can be easily evaluated without destruction, which differs from the conventional destructive inspection using an AFM, for example.

Further, obtaining the reference mark image in defect inspection can efficiently perform total inspection. In the defect inspection, simultaneously performing the evaluation method of the present invention enables the total inspection without increasing a time of the evaluation step. In addition, the reference mark with abnormal processing accuracy can be eliminated, and thereby a high-quality EUV mask blank can be provided. The high-quality EUV mask blanks can be provided stably and easily.

When the evaluation method of the present invention is integrated into the defect inspection, the present invention can be performed in the following flowchart.

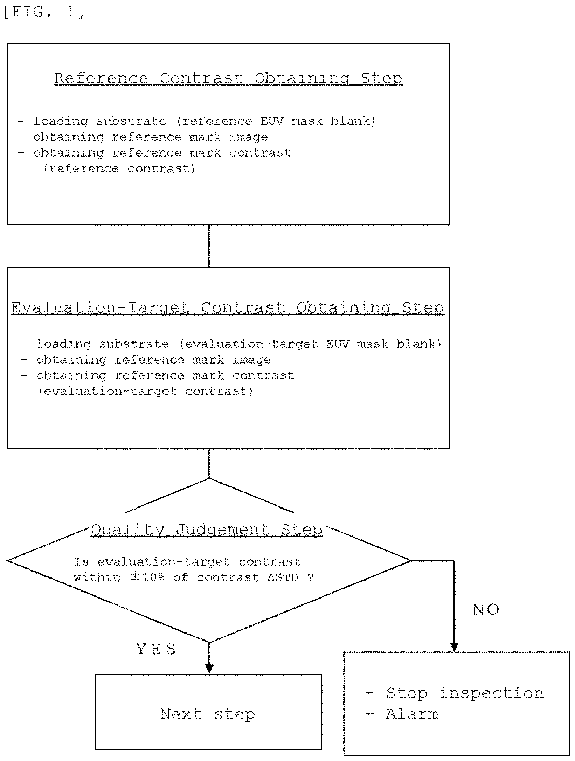

Described in FIG. 1 is a process example of an evaluation flowchart of the present invention using the reference mark contrast in EUV mask blank manufacturing.

As an evaluation apparatus, a defect inspection apparatus that can obtain the reference mark image may be used.

First, a program is constructed so that a sequential process of obtaining the reference mark image, obtaining the contrast, and judging the quality (comparing the contrasts) is automatically performed.

Then, as a preliminary test, the reference contrast obtaining step including loading the substrate, obtaining the reference mark image, and obtaining the reference mark contrast is performed in advance on the reference EUV mask blank. That is, the reference EUV mask blank having the produced reference mark with difference depths is loaded in the apparatus, the reference mark image is obtained, and the reference contrast $\Delta$REF is calculated. From the reference contrast $\Delta$REF, a target depth contrast $\Delta$STD is set, and a threshold in which products within $\Delta$STD±10% are judged as normal products is finally set in the evaluation apparatus.

After the above setting is finished, the evaluation-target EUV mask blank is inspected. The reference mark image is obtained from the evaluation-target EUV mask blank loaded in the apparatus in the reference mark image obtaining step, and the reference mark contrast (evaluation-target contrast) is automatically measured from the obtained image.

Then, the contrast of the inspected product (evaluation-target contrast) and the preset reference value (the contrast $\Delta$STD set from the reference contrast $\Delta$REF) are compared in the quality judgement step, and only a case where the difference is judged to be within ±10% is forwarded to the next step. Here, as for an evaluation-target EUV mask blank judged as abnormality, the inspection is stopped to generate alarm.

This inspection flowchart can quickly detect abnormality of the processing accuracy, such as depth, of the reference mark formed on the EUV mask blank, which has been difficult to judge the quality in the conventional method, and the process is smoothly improved.

(Second Embodiment)

Next, described is a case where correlation between the reference mark contrast and the depth of the reference mark is used as an indicator for evaluating processing accuracy of the reference mark formed on the EUV mask blank. In the first embodiment, the reference mark contrast itself is used as the indicator. However, in this embodiment, the depth of the reference mark, which has deep correlation with the reference mark contrast, obtained by conversion of the reference mark contrast is used as the indicator.

<Reference Contrast Obtaining Step>

A reference EUV mask blank having formed reference marks with varied depth conditions is prepared in advance. Then, these reference marks are imaged, and from this reference mark image, a reference mark contrast with each depth condition is obtained (reference contrast).

The depth of the reference mark can be measured by an AFM, etc.

The reference mark image and the reference contrast may be obtained in the same manner as in the first embodiment.

<Correlation Data Calculation Step>

From the reference contrast and the depth of the reference mark on the reference EUV mask blank determined as above, a correlation formula between the reference contrast and the depth of the reference mark is obtained.

<Evaluation-Target Contrast Obtaining Step>

Then, an evaluation-target EUV mask blank other than the reference EUV mask blank is prepared, a reference mark of the evaluation-target EUV mask blank is imaged with an optical system same as in the reference contrast obtaining step to obtain a reference mark image, and the reference mark contrast is obtained from the obtained reference mark image (evaluation-target contrast).

The reference mark image and the evaluation-target contrast may be obtained in the same manner as in the first embodiment.

<Quality Judgement Step>

By using the correlation formula between the reference contrast and the depth of the reference mark obtained in the correlation data calculation step, the depth of the reference mark on the evaluation-target EUV mask blank is evaluated from the evaluation-target contrast. As above, the depth-processing accuracy of the reference mark formed on the EUV mask blank can be easily evaluated without destruction, and quality of the reference mark can be judged.

The second embodiment as above can exhibit the aforementioned effects similarly to the first embodiment.

Note that, in evaluating the depth of the reference mark on the evaluation-target EUV mask blank, criteria in which the depth is within a predetermined percent of the target depth (this predetermined value is not limited, but specifically within ±10%) may be set as a normal value (good product). Alternatively, with an apparatus using the reference mark, a lower detection limit depth of the apparatus is evaluated and determined by evaluating the reference marks having different depths on the aforementioned reference EUV mask blank, and a case of the lower detection limit depth or higher (or a case of depth deeper than the lower detection limit depth) may also be set as a normal value (good product).

EXAMPLE

Hereinafter, the present invention will be more specifically described with showing Examples and Comparative Examples, but the present invention is not limited to these Examples.

(Example 1)

Among the methods for evaluating a reference mark of the present invention, the evaluation method using the reference mark contrast was performed.

First, on a square glass substrate with 6 inch (approximately 15 cm) on one side, molybdenum (Mo) film and silicon (Si) films were alternately stacked by a sputtering method using a molybdenum target and a silicon target as targets, and argon as a sputtering gas to form a Mo/Si multilayer reflective film to achieve reflectance of EUV light. Further, a ruthenium (Ru) film was formed as a protective film for protecting the multilayer reflective film to produce a reference EUV mask blank.

Then, on one reference EUV mask blank, reference marks #1 to #6 having difference depths were formed by varying processing conditions with FIB.

Measured values of the depths of these reference marks were measured by using an AFM. Table 1 shows the measured values of the depths of the reference marks #1 to #6. The reference marks with 30 nm to 80 nm in depth as the measured values were formed.

[Table 1]

| Reference mark | #1 | #2 | #3 | #4 | #5 | #6 |
|---|---|---|---|---|---|---|
| Depth (nm) | 30 | 42 | 50 | 59 | 70 | 80 |

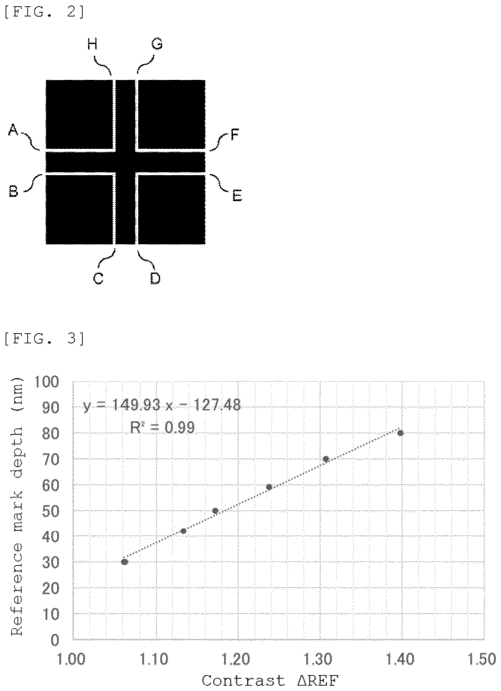

By using ABICS (E120), manufactured by Lasertec Corporation, an image of the above reference marks was obtained. From the obtained image, a reference mark contrast (contrasts $\Delta A$ to $\Delta H$), which was a difference in light intensity from the background level and determined from the aforementioned formula, was calculated on sides A to H of one reference mark having design illustrated in FIG. 2. An average value of these $\Delta A$ to $\Delta H$ was calculated here as a reference contrast $\Delta REF$.

Table 2 shows the results of $\Delta A$ to $\Delta H$ and $\Delta REF$ on the reference marks #1 to #6. FIG. 3 shows a graph in which the measured depth values of the reference marks #1 to #6 and the reference contrast $\Delta REF$ were plotted.

[Table 2]

| Reference mark | #1 | #2 | #3 | #4 | #5 | #6 |
|---|---|---|---|---|---|---|
| $\Delta A$ | 1.06 | 1.14 | 1.15 | 1.21 | 1.28 | 1.37 |
| $\Delta B$ | 1.05 | 1.13 | 1.13 | 1.21 | 1.25 | 1.33 |
| $\Delta C$ | 1.05 | 1.13 | 1.19 | 1.27 | 1.33 | 1.45 |
| $\Delta D$ | 1.05 | 1.13 | 1.21 | 1.27 | 1.36 | 1.44 |
| $\Delta E$ | 1.05 | 1.14 | 1.16 | 1.22 | 1.29 | 1.37 |
| $\Delta F$ | 1.05 | 1.12 | 1.13 | 1.21 | 1.25 | 1.32 |
| $\Delta G$ | 1.10 | 1.13 | 1.19 | 1.25 | 1.32 | 1.44 |
| $\Delta H$ | 1.10 | 1.14 | 1.21 | 1.26 | 1.37 | 1.45 |
| $\Delta REF$ | 1.06 | 1.13 | 1.17 | 1.24 | 1.31 | 1.40 |

It was confirmed from this result that the reference contrast $\Delta REF$ had correlation with the depth of the reference mark.

Here, a target contrast $\Delta STD$ was set to $\Delta STD = 1.19$.

Then, on each of EUV mask blanks: LOT (a), (b), and (c), which were formed under film-forming conditions same as the above reference EUV mask blank, four reference marks of MARK 1, MARK 2, MARK 3, and MARK 4 were produced by the FIB with the design same as #1 to #6 and illustrated in FIG. 2 under processing conditions for a target of $\Delta STD=1.19$ (target of 50 nm in depth) to prepare evaluation-target EUV mask blanks. By using the ABICS, manufactured by Lasertec Corporation, images of the reference marks were obtained under the same illumination conditions. From the obtained images, reference mark contrasts (contrasts $\Delta A$ to $\Delta H$) were calculated from the sides A to H illustrated in FIG. 2 and a background level, and an evaluation-target contrast $\Delta_{AVE}$ was calculated from an average value of the contrasts.

Table 3 shows the $\Delta_{AVE}$ of MARK 1 to 4.

[Table 3]

| LOT | (a) | (b) | (c) |
|---|---|---|---|
| MARK1 | 1.21 | 1.18 | 1.06 |
| MARK2 | 1.19 | 1.18 | 1.22 |
| MARK3 | 1.22 | 1.19 | 1.21 |
| MARK4 | 1.22 | 1.20 | 1.18 |

From this result, a case where the evaluation-target contrast was within $\pm 10\%$ of the target contrast $\Delta STD$ (1.07 to 1.31) was set here as quality judgement criteria.

Based on these set criteria, MARK 1 of LOT (c) was judged as abnormality, and only LOT (a) and LOT (b) were judged to be treated as good products.

(Example 2)

Among the methods for evaluating a reference mark of the present invention, performed was the evaluation method using a depth value converted from a correlation formula between a reference mark contrast and a depth of a reference mark.

From depths of the reference marks #1 to #6 evaluated in Example 1 and FIG. 3, which was a plot graph of the reference contrast $\Delta$REF, the following correlation formula was calculated.

Correlation formula: Depth of reference mark = 149.93$\times\Delta$REF-127.48

Then, the evaluation-target contrast $\Delta_{AVE}$ of MARK 1 to 4 of LOT (a) to (c), which targeted 50 nm in depth, produced in Example 1 were converted into depths $D_{AVE}$ by using the above correlation formula. Table 4 shows the depths $D_{AVE}$ of MARK 1 to 4.

[Table 4]

| LOT | (a) | (b) | (c) |
|---|---|---|---|
| MARK1 | 54nm | 49nm | 31nm |
| MARK2 | 51nm | 49nm | 55nm |
| MARK3 | 55nm | 51nm | 54nm |
| MARK4 | 55nm | 52nm | 49nm |

From this result, a case where the depth $D_{AVE}$ was within $\pm$10% of the target value 50 nm (45 nm to 55 nm) was set here as quality judgement criteria.

Based on these set criteria, MARK 1 of LOT (c) was judged as abnormality, and only LOT (a) and LOT (b) were judged to be treated as good products.

(Verification)

As noted above, the target depth of the reference mark in Examples 1 and 2 was 50 nm (range of depth-processing accuracy of good products: 45 to 55 nm).

The depths of the reference marks of LOT (a), (b), and (c) were actually measured with an AFM, and the measured values were same as in the results shown in Table 4. That is, only MARK 1 of LOT (c) was abnormal and the others were normal, namely LOT (a) and (b) were good products, similarly to the judgement results in Examples 1 and 2. Accordingly, it is found that the evaluation method of the present invention is effective.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

**Claims**

1. A method for evaluating a reference mark formed on an EUV mask blank, the method comprising steps of:

imaging the reference mark formed on the EUV mask blank to obtain a reference mark image;
obtaining a reference mark contrast from the obtained reference mark image, the reference mark contrast being contrast between the reference mark and a background level; and
evaluating processing accuracy of the reference mark with the obtained reference mark contrast.

2. The method for evaluating a reference mark formed on an EUV mask blank according to claim 1, wherein evaluating the processing accuracy of the reference mark comprises:

a reference contrast obtaining step of preparing in advance a reference EUV mask blank with a varied depth of a reference mark, and obtaining a reference mark contrast of the reference EUV mask blank as a reference contrast;

an evaluation-target contrast obtaining step of preparing an evaluation-target EUV mask blank other than the reference EUV mask blank, and obtaining a reference mark contrast of the evaluation-target EUV mask blank as an evaluation-target contrast with an optical system same as in the reference contrast obtaining step; and a quality judgement step of comparing the evaluation-target contrast and the reference contrast to judge quality of the reference mark of the evaluation-target EUV mask blank.

3. The method for evaluating a reference mark formed on an EUV mask blank according to claim 1, wherein evaluating the processing accuracy of the reference mark comprises:

a reference contrast obtaining step of preparing in advance a reference EUV mask blank with a varied depth of a reference mark, and obtaining a reference mark contrast of the reference EUV mask blank as a reference contrast;

a correlation data calculation step of obtaining a correlation formula between the reference contrast and the depth of the reference mark from the reference contrast and the depths of the reference marks in the reference EUV mask blank;

an evaluation-target contrast obtaining step of preparing an evaluation-target EUV mask blank other than the reference EUV mask blank, and obtaining a reference mark contrast of the evaluation-target EUV mask blank as an evaluation-target contrast with an optical system same as in the reference contrast obtaining step; and a quality judgement step of evaluating the depth of the reference mark of the evaluation-target EUV mask blank from the evaluation-target contrast and the correlation formula obtained in the correlation data calculation step to judge quality of the reference mark of the evaluation-target EUV mask blank.

4. The method for evaluating a reference mark formed on an EUV mask blank according to any one of claims 1 to 3, wherein, in imaging the reference mark formed on the EUV mask blank to obtain the reference mark image, the reference mark is imaged with a Schwarzschild optical system and with a dark-field inspection image.

[FIG. 1]

```
┌─────────────────────────────────────────────────────────┐
│                                                          │
│        Reference Contrast Obtaining Step                 │
│                                                          │
│  - loading substrate (reference EUV mask blank)          │
│  - obtaining reference mark image                        │
│  - obtaining reference mark contrast                     │
│      (reference contrast)                                │
│                                                          │
│                                                          │
└─────────────────────────────────────────────────────────┘
                            │
┌─────────────────────────────────────────────────────────┐
│                                                          │
│  Evaluation-Target Contrast Obtaining Step               │
│                                                          │
│   - loading substrate (evaluation-target EUV mask blank) │
│   - obtaining reference mark image                       │
│   - obtaining reference mark contrast                    │
│     (evaluation-target contrast)                         │
│                                                          │
│                                                          │
└─────────────────────────────────────────────────────────┘
                            │
```

Quality Judgement Step

Is evaluation-target contrast
within ±10% of contrast ΔSTD ?

YES

NO

```
┌──────────────────────┐   ┌──────────────────────┐
│                      │   │  - Stop inspection   │
│     Next step        │   │  - Alarm             │
│                      │   │                      │
└──────────────────────┘   └──────────────────────┘
```

[FIG. 2]

[FIG. 3]

**EP 4 446 809 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014129527 A1
- JP 2017227936 A
- JP 2003114200 A